# EUROPEAN PATENT APPLICATION

(11) **EP 2 413 455 A1**
(43) Date of publication of application: **01.02.2012**
(21) Application number: 11166897.6
(22) Date of filing: 20.05.2011
(51) Int. Cl.: H02J 7/00, H01H 9/54, H01M 10/50, H02M 5/00

(54) **Battery heating circuit**

(30) Priority: 30.07.2010 CN 201010245288; 30.08.2010 CN 201010274785; 23.12.2010 CN 201010604744
(71) Applicant: Byd Company Limited, Shenzhen 518118 (CN)
(72) Inventor: Xu, Wenhui, 518118, Shenzhen (CN); Han, Yaochuan, 518118, Shenzhen (CN); Feng, Wei, 518118, Shenzhen (CN); Yang, Qinyao, 518118, Shenzhen (CN); Xia, Wenjin, 518118, Shenzhen (CN); Ma, Shibin, 518118, Shenzhen (CN)
(74) Representative: Fritsche, Daniel

(57) **Abstract**

The present invention provides a battery heating circuit, wherein, the battery comprises a first battery (E1) and a second battery (E2), the heating circuit comprises a first switch unit (10), a second switch unit (20), a damping element R1, a damping element R2, a current storage element L1, a current storage element L2, a switching control module (100) and a charge storage element C, the first battery, damping element R1, current storage element L1, first switch unit (10) and charge storage element C are connected in series to form a first charging/discharging circuit; the second battery (E2), damping element R2, current storage element L2, charge storage element C and second switch unit (20) are connected in series to form a second charging/discharging circuit; when the charge storage element C is charged or discharges, the direction of charging/discharging current in the second charging/discharging circuit is reverse to the direction of charging/discharging current in the first charging/discharging circuit; the switching control module (100) is electrically connected with the first switch unit (10) and second switch unit (20), and is configured to control the electric energy flow between the first battery (E1), charge storage element C and second battery (E2). The battery heating circuit of the present invention can achieve high heating efficiency.

## Description

### Technical Field of the Invention

The present invention pertains to electric and electronic field, in particular to a battery heating circuit.

### Background of the Invention

In view cars have to run under complex road conditions and environmental conditions or some electronic devices are used under harsh environmental conditions, the battery, which serves as the power supply unit for electric motor cars or electronic devices, must be adaptive to these complex conditions. In addition, besides these conditions, the service life and charging/discharging cycle performance of battery must be considered; especially, when electric motor cars or electronic devices are used in low temperature environments, the battery must have outstanding low temperature charging/discharging performance and higher input/output power.

Usually, under low temperature conditions, the resistance of battery will increase, and the polarization will increase; therefore, the capacity of battery will be reduced.

To keep the capacity of battery and improve the charging/discharging performance of battery under low temperature conditions, the present invention provides a battery heating circuit.

### Summary of the Invention

The object of the present invention is to provide a battery heating circuit, in order to solve the problem of decreased capacity of battery caused by increased resistance and polarization of battery under low temperature conditions.

The present invention provides a battery heating circuit, wherein, the battery comprises a first battery and a second battery, the heating circuit comprises a first switch unit, a second switch unit, a damping element R1, a damping element R2, a current storage element L1, a current storage element L2, a switching control module and a charge storage element C, the first battery, damping element R1, current storage element L1, first switch unit and charge storage element C are connected in series to form a first charging/discharging circuit; the second battery, damping element R2, current storage element L2, charge storage element C and second switch unit are connected in series to form a second charging/discharging circuit; when the charge storage element C is charged or discharges, the direction of charging/discharging current in the second charging/discharging circuit is reverse to the direction of charging/discharging current in the first charging/discharging circuit; the switching control module is electrically connected with the first switch unit and second switch unit, and is configured to control the first switch unit and second switch unit to switch on in alternate, so as to control the electric energy to flow between the first battery, charge storage element C and second battery.

In the heating circuit provided in the present invention, the first switch unit and second switch unit can be controlled by the switching control module to switch on in alternate, so that the electric energy can flow to and fro between the first battery, charge storage element C and second battery in alternate, and thereby causes the damping element R1 and damping element R2 to generate heat, so as to heat up the first battery and second battery. Since the direction of charging/discharging current in the second charging/discharging circuit is reverse to the direction of charging/discharging current in the first charging/discharging circuit when viewed from the aspect of the charge storage element C, the energy charged from the first battery into the charge storage element C can be transferred successfully to the second battery, so that the heating efficiency is improved.

In the heating circuit provided in the present invention, the charge storage element is connected with the battery in series; when the battery is heated, safety problems related with failure or short circuit of the switch unit can be avoided owing to the existence of the charge storage element, and therefore the battery can be protected effectively.

Other characteristics and advantages of the present invention will be further detailed in the embodiments hereunder.

### Brief Description of the Drawings

The accompanying drawings are provided here to facilitate further understanding on the present invention, and are a part of this document. They are used together with the following embodiments to explain the present invention, but shall not be comprehended as constituting any limitation to the present invention. In the figures:
Figure 1 is a schematic diagram of the heating circuit in the first embodiment of the present invention.
Figure 2 is a timing sequence diagram of waveform of the heating circuit in the first embodiment of the present invention.
Figure 3 is a schematic diagram of the heating circuit in the second embodiment of the present invention.
Figure 4 is a timing sequence diagram of waveform of the heating circuit in the second embodiment of the present invention.
Figure 5 is a schematic diagram of the heating circuit in the third embodiment of the present invention.
Figure 6 is a timing sequence diagram of waveform of the heating circuit in the third embodiment of the present invention.
Figure 7 is a circuit diagram of an embodiment of the first and/or second switch unit in the heating circuit provided in the present invention.

### Detailed Description of the Embodiments

Hereunder the embodiments of the present invention will be detailed, with reference to the accompanying drawings. It should be appreciated that the embodiments described here are only provided to describe and explain the present invention, but shall not be deemed as constituting any limitation to the present invention.

Please note: unless otherwise specified, where mentioned in the following text, the term "switching control module" refers to any controller that can output control commands (e.g., pulse waveform) under preset conditions or at preset times and thereby controls the switch unit connected to it to switch on or switch off accordingly, for example, the switching control module can be a PLC; where mentioned in the following text, the term "switch" refers to a switch that achieve ON/OFF control by means of electrical signals or achieve ON/OFF control on the basis of the characteristics of the element or component, which is to say, the switch can be an one-way switch (e.g., a switch composed of a two-way switch and a diode connected in series, which can switch on in one direction) or a two-way switch (e.g., a Metal Oxide Semiconductor Field Effect Transistor (MOSFET) or an IGBT with an anti-parallel freewheeling diode); where mentioned in the following text, the term "two-way switch" refers to a switch that can switch on in two ways, which can achieve ON/OFF control by means of electrical signals or achieve ON/OFF control on the basis of the characteristics of the element or component, for example, the two-way switch can be a MOSFET or an IGBT with an anti-parallel freewheeling diode; where mentioned in the following text, the term "one-way semiconductor element" refers to a semiconductor element that can switch on in one direction, such as an diode; where mentioned in the following text, the term "charge storage element" refers to any device that can implement charge storage, such as a capacitor; where mentioned in the following text, the term "current storage element" refers to any device that can store current, such as an inductor; where mentioned in the following text, the term "forward direction" refers to the direction in which the energy flows from the battery to the energy storage circuit, and the term "reverse direction" refers to the direction in which the energy flows from the energy storage circuit to the battery; where mentioned in the following text, the term "battery" comprises primary battery (e.g., dry battery or alkaline battery, etc.) and secondary battery (e.g., lithium-ion battery, nickel-cadmium battery, nickel-hydrogen battery, or lead-acid battery, etc.); where mentioned in the following text, the term "damping element" refers to any device that inhibits current flowing and thereby achieves energy consumption, such as a resistor; where mentioned in the following text, the term "main loop" refers to a loop composed of battery, damping element, switch unit and energy storage circuit connected in series.

It should be noted specially: in view different types of batteries have different characteristics, in the present invention, the "battery" refers to an ideal battery that doesn't have internal parasitic resistance and inductance or has very low internal parasitic resistance and inductance, or refers to a battery pack that has internal parasitic resistance and inductance; therefore, those skilled in the art should appreciate: if the battery is an ideal battery that doesn't have internal parasitic resistance and inductance or has very low internal parasitic resistance and inductance, the damping element refers to an damping element external to the battery, and the current storage element L1 and L2 refer to current storage elements external to the battery; if the battery is a battery pack that has internal parasitic resistance and inductance, the damping element refers to a damping element external to the battery, or refers to the parasitic resistance in the battery pack; likewise, the current storage element L1 and L2 refer to a current storage elements external to the battery, or refer to the parasitic inductances in the battery pack.

To ensure the normal service life of the battery, the battery can be heated under low temperature condition, which is to say, when the heating condition is met, the heating circuit is controlled to start heating for the battery; when the heating stop condition is met, the heating circuit is controlled to stop heating.

In the actual application of battery, the battery heating condition and heating stop condition can be set according to the actual ambient conditions, to ensure normal charging/discharging performance of the battery.

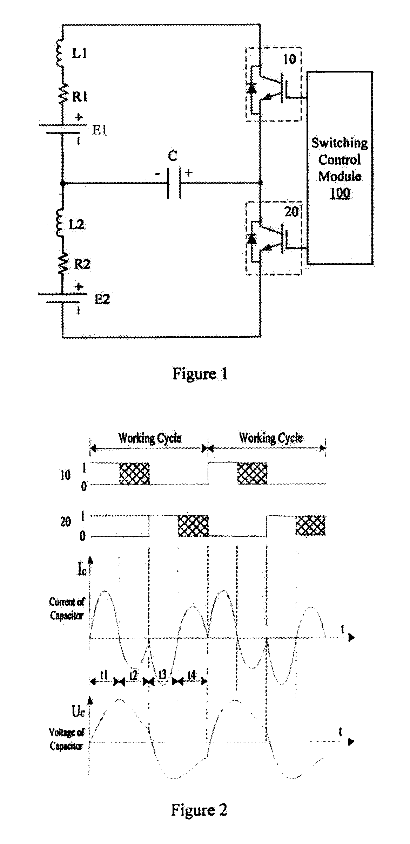

Figure 1 is a schematic diagram of the heating circuit in the first embodiment of the present invention. As shown in Figure 1, the present invention provides a battery heating circuit, wherein, the battery comprises a first battery E1 and a second battery E2, the heating circuit comprises a first switch unit 10, a second switch unit 20, a damping element R1, a damping element R2, a current storage element L1, a current storage element L2, a switching control module 100 and a charge storage element C; the first battery E1, damping element R1, current storage element L1, first switch unit 10 and charge storage element C are connected in series to form a first charging/discharging circuit; the second battery E2, damping element R2, current storage element L2, charge storage element C and second switch unit 20 are connected in series to form a second charging/discharging circuit; when the charge storage element C is charged or discharges, the direction of charging/discharging current in the second charging/discharging circuit is reverse to the direction of charging/discharging current in the first charging/discharging circuit; the switching control module 100 is electrically connected with the first switch unit 10 and second switch unit 20, and is configured to control the first switch unit 10 and second switch unit 20 to switch on in alternate, so as to control the electric energy flow between the first battery E1, charge storage element C and second battery E2.

Wherein, the switching control module 100 can control the first switch unit 10 and second switch unit 20 to switch on or off, for example, the first switch unit 10 switches from ON state to OFF state, while the second switch unit 20 switches from OFF state to ON state, so that the electric energy stored in the charge storage element C from one battery can flow into the other battery. As the electric energy flows, current is generated; by keeping current flowing through the damping element R1 and damping element R2 continuously, the damping element R1 and damping element R2 generate heat, and thereby heat up the first battery E1 and second battery E2.

Figure 2 is a timing sequence diagram of waveform of the heating circuit in the first embodiment of the present invention. Hereunder the working process of the heating circuit provided in the present invention will be described, with reference to Figure 2. First, the switching control module 100 controls the first switch unit 10 to switch on, and controls the second switch unit 20 to switch off; the first battery E1, damping element R1, current storage element L1, first switch unit 10 and charge storage element C form a charging/discharging circuit, which performs charging/discharging operations (as indicated by the time period t1~t2 shown in Figure 2, wherein, the time period t1 represents the charging time period of the charging/discharging circuit; at the end of the time period t1, the capacitive voltage U_{C} of the charge storage element C is the peak value in half cycle, and the capacitive current I_{C} reaches to zero after the positive half cycle; the time period t2 represents the discharging time period of the charging/discharging circuit). After a charging/discharging cycle is completed (at this point, the current I_{C} through the charge storage element C reaches to zero after the negative half cycle), the switching control module 100 controls the first switch unit 10 to switch off, and controls the second switch unit 20 to switch on; the second battery E2, damping element R2, current storage element L2, charge storage element C, and second switch unit 20 form a charging/discharging circuit, which performs charging/discharging operations (as indicated by the time period t3~t4 shown in Figure 2, wherein, the time period t3 represents the charging time period of the charging/discharging circuit, while the time period t4 represents the discharging time period of the charging/discharging circuit). After the charging/discharging circuit completes a charging/discharging cycle (at this point, the current I_{C} through charge storage element C reaches to zero after the positive half cycle, and the entire heating circuit accomplishes a complete working cycle), the switching control module 100 controls the first switch unit 10 to switch on and controls the switch unit 20 to switch off again; in that way, the cycles continue on, so that the current flows through the damping element R1 and damping element R2 continuously; as a result, the damping element R1 and damping element R2 generate heat, and thereby heat up the first battery E1 and second battery E2 to the expected condition.

In the above working process of the heating circuit provided in the present invention, the current can be kept flowing to and fro between the first battery E1 and the second battery E2, so that two batteries are heated up in alternate, and therefore the heating efficiency is improved.

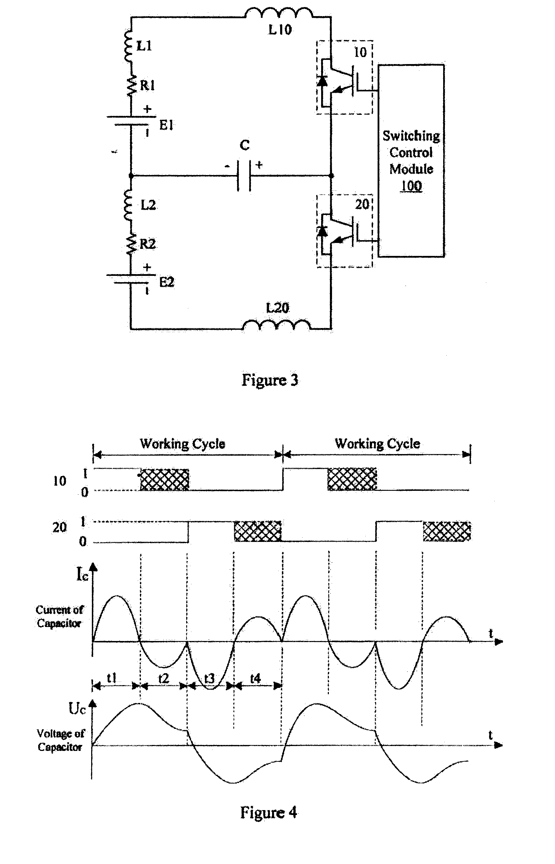

Figure 3 is a circuit diagram of the heating circuit in the second embodiment of the present invention. Preferably, as shown in Figure 3, the heating circuit provided in the present invention further comprises a current storage element L10 and a current storage element L20, wherein, the current storage element L10 is connected in series in the first charging/discharging circuit, and the current storage element L20 is connected in series in the second charging/discharging circuit. Thereby, the current storage element L10 and current storage element L20 can be utilized to implement current limiting for the capacitive current I_{c} (i.e., the current flow through the first and second batteries and the first and second switch units) in both directions, so as to decrease the magnitude of current flowing through the first and second batteries and the first and second switch units, and attain the purpose of protecting the first and second batteries and the first and second switch units. Figure 4 is a timing sequence diagram of waveform of the heating circuit in the second embodiment of the present invention. As shown in Figure 4, compared to the capacitive current I_{c} shown in Figure 2, the capacitive current I_{C} shown in Figure 4 has a smoother waveform, with peak value and valley value much smaller than the peak value and valley value of the capacitive current I_{C} shown in Figure 2.

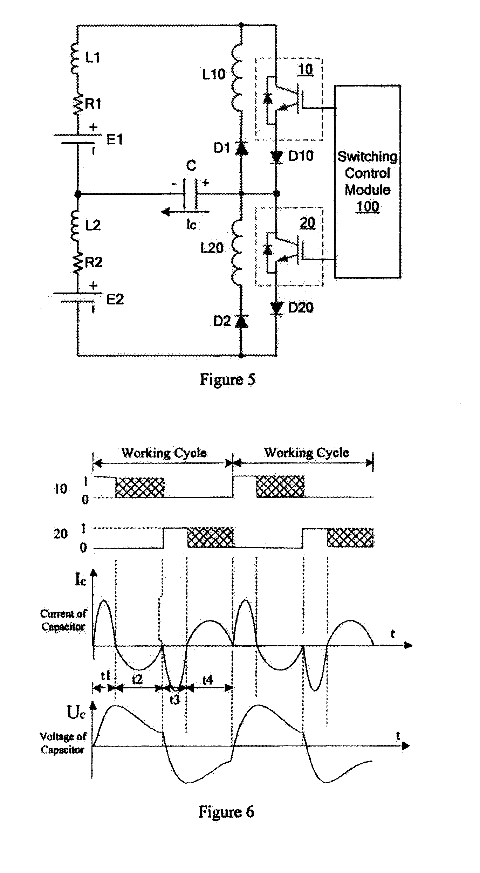

Figure 5 is a circuit diagram of the heating circuit in the third embodiment of the present invention. Preferably, as shown in Figure 5, the heating circuit provided in the present invention can further comprise a current storage element L10, a current storage element L20, an one-way semiconductor element D1, an one-way semiconductor element D2, an one-way semiconductor element D10 and an one-way semiconductor element D20, wherein, the one-way semiconductor element D10 is connected in series with the first switch unit 10, the current storage element L10 and one-way semiconductor element D1 connected in series with each other are connected in parallel between the ends of the one-way semiconductor element D10 and first switch unit 10 connected in series with each other, so as to limit the current in the first charging/discharging circuit in reverse direction; and, the one-way semiconductor element D20 is connected in series with the second switch unit 20, and the current storage element L20 and one-way semiconductor element D2 connected in series with each other are connected in parallel between the ends of the one-way semiconductor element D20 and second switch unit 20 connected in series with each other, so as to limit the current in the second charging/discharging circuit in reverse direction. Thereby, the capacitive current (i.e., current flowing through the first battery E1 and second battery E2) is limited in one direction (i.e., current limiting during charging of the first battery E1 and second battery E2). Thus, compared to the heating circuit (two-way current limiting) in the second embodiment, the heating circuit here can further improve the heating efficiency on the premise of protecting the first and second batteries and the first and second switch units. Figure 6 is a timing sequence diagram of waveform of the heating circuit in the third embodiment of the present invention. As shown in Figure 6, compared to the capacitive current I_{c} shown in Figure 4, the capacitive current I_{c} shown in Figure 6 has a higher peak value in the positive half cycle.

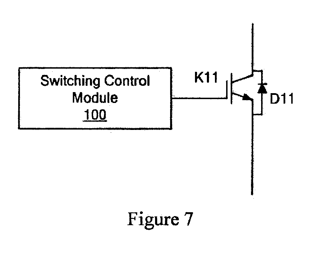

Figure 7 is a circuit diagram of an embodiment of the switch unit in the heating circuit provided in the present invention. As shown in Figure 7, the first switch unit 10 and/or the second switch unit 20 can comprise a switch K1 and a one-way semiconductor element D11 connected in parallel with the switch K11 in reverse direction, wherein, the switching control module 100 is electrically connected with the switch K11, and is configured to control ON/OFF of the forward direction branches of the first switch unit 10 and/or the second switch unit 20 by controlling ON/OFF of the switch K11. The ON/OFF control of switch K11 can be performed in the grid zone shown in Figure 2, Figure 4 and Figure 6. When or after the current flow through the first switch unit 10 or the second switch unit 20 reaches to zero, the switching control module 100 can control the first switch unit 10 or second switch unit 20 to switch off.

The heating circuit provided in the present invention has the following advantages:
(1) When viewed from the aspect of the charge storage element, the direction of charging/discharging current in the second charging/discharging circuit is reverse to the direction of charging/discharging current in the first charging/discharging circuit; therefore, the electric energy can flow to and fro between the first battery, charge storage element and second battery in alternate, and thereby the resultant current causes the damping element R1 and damping element R1 to generate heat, so that the first and second batteries are heated up; in that way, the first and second batteries are heated in alternate, and the heating efficiency is high.
(2) Since the current storage element provides current limiting function and only one charging/discharging circuit is formed in each time cycle, the current flowing through the first and second batteries and the current flowing through the first and second switch units are lower; in addition, owing to the composition of the charging/discharging circuit and the existence of the current storage element L10 and L20, the current flowing through the first and second batteries and the current flowing through the first and second switch units can be further limited, so as to avoid damage to the batteries and switch units resulted from heavy current.
(3) With the one-way current limiting scheme, the discharging efficiency of the first and second batteries is improved, and the charging current in reverse direction is limited to prevent damage to the first and second batteries; therefore, the heating efficiency can be improved on the premise of protecting the first and second batteries and the switch units against damage.
(4) In the heating circuit provided in the present invention, the charge storage element is connected with the battery in series; when the battery is heated, safety problems related with failure or short circuit of the switch unit can be avoided owing to the existence of the charge storage element, and therefore the battery can be protected effectively.

While some preferred embodiments of the present invention are described above with reference to the accompanying drawings, the present invention is not limited to the details in those embodiments. Those skilled in the art can make modifications and variations to the technical scheme of the present invention, without departing from the spirit of the present invention. However, all these modifications and variations shall be deemed as falling into the protected domain of the present invention.

In addition, it should be noted: the specific technical features described in above embodiments can be combined in any appropriate form, provided that there is no conflict. To avoid unnecessary repetition, the possible combinations are not described specifically in the present invention. Moreover, the different embodiments of the present invention can be combined freely as required, as long as the combinations don't deviate from the ideal and spirit of the present invention. However, such combinations shall also be deemed as falling into the scope disclosed in the present invention.

## Claims

1. A battery heating circuit, wherein, the battery comprises a first battery (E1) and a second battery (E2), the heating circuit comprises a first switch unit (10), a second switch unit (20), a damping element R1, a damping element R2, a current storage element L1, a current storage element L2, a switching control module (100) and a charge storage element C,
the first battery (E1), the damping element R1, the current storage element L1, the first switch unit (10) and the charge storage element C are connected in series to form a first charging/discharging circuit;
the second battery (E2), the damping element R2, the current storage element L2, the charge storage element C and the second switch unit (20) are connected in series to form a second charging/discharging circuit; when the charge storage element C is charged or discharges, the direction of charging/discharging current in the second charging/discharging circuit is reverse to the direction of charging/discharging current in the first charging/discharging circuit;
the switching control module (100) is electrically connected with the first switch unit (10) and the second switch unit (20), and the switching control module (100) is configured to control the first switch unit (10) and the second switch unit (20) to switch on in alternate, so as to control the electric energy flow among the first battery (E1), the charge storage element C and the second battery (E2).

2. The battery heating circuit according to claim 1, wherein the damping element R1 and the damping element R2 are the parasitic resistances in the first battery (E1) and the second battery (E2) respectively, the current storage element L1 and the current storage element L2 are the parasitic inductances in the first battery (E1) and the second battery (E2) respectively, and the charge storage element C is a capacitor.

3. The battery heating circuit according to claim 1, wherein the heating circuit further comprises a current storage element L10 and a current storage element L20, wherein, the current storage element L10 is connected in series in the first charging/discharging circuit, and the current storage element L20 is connected in series in the second charging/discharging circuit.

4. The battery heating circuit according to claim 3, wherein the current storage element L10 and current storage element L20 are inductors.

5. The battery heating circuit according to claim 1, wherein the heating circuit further comprises a current storage element L10, a current storage element L20, an one-way semiconductor element D1, an one-way semiconductor element D2, an one-way semiconductor element D10 and an one-way semiconductor element D20, wherein,
the one-way semiconductor element D10 is connected in series with the first switch unit (10), the one-way semiconductor element D1 and the current storage element L10 connected in series with each other are connected in parallel between the ends of the one-way semiconductor element D10 and the first switch unit (10) connected in series with each other, so as to limit the current in the first charging/discharging circuit in reverse direction; and,
the one-way semiconductor element D20 is connected in series with the second switch unit (20), and the current storage element L20 and one-way semiconductor element D2 connected in series with each other are connected in parallel between the ends of the one-way semiconductor element D20 and the second switch unit (20) connected in series with each other, so as to limit the current in the second charging/discharging circuit in reverse direction.

6. The battery heating circuit according to claim 5, wherein the current storage element L10 and current storage element L20 are inductors.

7. The battery heating circuit according to any one of claims 1 to 6, wherein the first switch unit (10) and/or the second switch unit (20) comprise a switch K11 and a one-way semiconductor element D11 connected in parallel with the switch K11 in reverse direction, and the switching control module (100) is electrically connected with the switch K11, and the switching control module (100) is configured to control ON/OFF of the forward direction branches of the first switch unit (10) and/or the second switch unit (20) by controlling ON/OFF of the switch K11.

8. The battery heating circuit according to claim 7, wherein when or after the current flowing through the first switch unit (10) or the second switch unit (20) reaches to zero, the switching control module (100) is configured to control the first switch unit (10) or the second switch unit (20) to switch off respectively.
